(19) Europäisches Patentamt
European Patent Office
Office européen des brevets

(11) **EP 4 591 083 B1**

(12) **EUROPÄISCHE PATENTSCHRIFT**

(45) Veröffentlichungstag und Bekanntmachung des Hinweises auf die Patenterteilung:
**18.02.2026 Patentblatt 2026/08**

(21) Anmeldenummer: **24801513.3**

(22) Anmeldetag: **04.11.2024**

(51) Internationale Patentklassifikation (IPC):
**G01R 31/74** (2020.01)     **H02H 3/04** (2006.01)
**B60L 3/04** (2006.01)

(52) Gemeinsame Patentklassifikation (CPC):
**G01R 31/74; H02H 3/046;** G01R 31/54

(86) Internationale Anmeldenummer:
**PCT/EP2024/081059**

(87) Internationale Veröffentlichungsnummer:
**WO 2025/124800 (19.06.2025 Gazette 2025/25)**

(54) **TESTVERFAHREN UND TESTSYSTEM ZUM TESTEN VON EFUSES**

TEST METHOD AND TEST SYSTEM FOR TESTING EFUSES

PROCÉDÉ ET SYSTÈME DE TEST DE FUSIBLES

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **16.12.2023 DE 102023005197**

(43) Veröffentlichungstag der Anmeldung:
**30.07.2025 Patentblatt 2025/31**

(73) Patentinhaber: **Mercedes-Benz Group AG**
**70372 Stuttgart (DE)**

(72) Erfinder: **HUSSEIN, Islam**
**70599 Stuttgart (DE)**

(74) Vertreter: **Novagraaf Group**
**Chemin de l'Echo 3**
**1213 Onex / Geneva (CH)**

(56) Entgegenhaltungen:
CN-A- 116 960 892     DE-B3- 102016 114 740
US-A1- 2009 079 439     US-A1- 2010 225 330

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Testen von schaltbaren elektronischen Sicherungen gemäß dem Oberbegriff des Anspruchs 1. Ferner betrifft die Erfindung ein Testsystem zum Testen von schaltbaren elektronischen Sicherungen gemäß dem Oberbegriff des Anspruchs 8.

Elektronische Sicherungen, im Folgenden als Efuses ("electronic fuses") bezeichnet, sind Halbleiterschaltungen zur Begrenzung oder Unterbrechung eines von einer elektrischen Last aufgenommenen Stroms. Analog zu klassischen Schmelzsicherungen werden Efuses zerstört, wenn sie in einem Überstromfall (beispielsweise bei einem in der elektrischen Last auftretenden Kurzschluss) für eine vorbestimmte Zeit von einem Strom durchflossen werden, der oberhalb eines zulässigen Nennstromwertes liegt. Eine in einem Überstromfall korrekt zerstörte Efuse ist typischerweise dauerhaft (irreversibel) nichtleitend, jedoch sind auch rücksetzbare Efuses bekannt, die nach einem Überstromfall zurück in den Ausgangszustand versetzt werden können.

Schaltbare Efuses sind bis zum Eintreten eines Überstromfalls elektronisch zwischen einem leitenden und einem nicht-leitenden Zustand umschaltbar. Beispielsweise kann eine schaltbare Efuse als Feldeffekttransistor, beispielsweise als n-Kanal-Metall-Oxid-Halbleiter-Feldeffekttransistor ausgebildet sein, der über eine an die Gate-Elektrode angelegte Spannung zwischen einem leitenden und einem nicht-leitenden Zustand umschaltbar ist.

Durch Fehler bei der Fertigung oder im Betrieb oder durch eine alterungsbedingte Degradation von Efuses ist es möglich, dass im Überstromfall die zu schützende elektrische Last nicht sicher von der Versorgungsspannung getrennt wird. Dadurch wird die Betriebssicherheit der elektrischen Last beeinträchtigt. Beispielsweise kann, wenn eine solche elektrische Last ein sicherheitskritisches elektrisches Teilsystem eines Fahrzeugs ist, die Betriebssicherheit des Fahrzeugs beeinträchtigt sein. Daher ist es erforderlich, den Arbeitszustand solcher Efuses regelmäßig zu überprüfen.

Hierzu kann die Efuse in einem Betriebsmodus mit abgehängter elektrischer Last getestet werden, bei einem Fahrzeug beispielsweise in einem Parkzustand mit abgeschaltetem sicherheitskritischem elektrischem Teilsystem. Dieses Verfahren ist jedoch für die Überprüfung des Arbeitszustands einer Efuse im laufenden Betrieb nicht anwendbar und eignet sich daher nicht für eine fortlaufende Überwachung.

Ferner kann parallel zu einer ersten Efuse eine redundante zweite Efuse zwischen einer Versorgungsspannungsquelle und einer zu schützenden elektrischen Last angeordnet werden. Beide Efuses können dann abwechselnd von der elektrischen Last getrennt und isoliert getestet werden, ohne die Versorgung der elektrischen Last zu beeinträchtigen. Diese Redundanz führt jedoch zu erhöhten Fertigungs- und Betriebskosten, beispielsweise aufgrund eines erhöhten Platzbedarfs auf Leiterplatten oder Chips und/oder zu einer erhöhten Leistungsaufnahme, weil zusätzliche Efuses bereitgestellt werden müssen.

Das Dokument US 2001/0034070 A1 beschreibt eine Vorrichtung und ein Verfahren zum Testen von Sicherungen in einer Speichervorrichtung. Über einem Kontrollwiderstand wird eine Spannung angelegt, die über die Zeit abfällt. Die über dem Kontrollwiderstand abfallende Spannung wird mittels eines Komparators mit einem Referenzspannungswert verglichen. Es wird die Zeitdauer ermittelt, nach der der Komparator seinen Zustand ändert. Sicherungen werden durch Vergleich mit dieser ermittelten Zeitdauer getestet, indem über der zu testenden Sicherung eine abklingende Spannung angelegt wird und die Zeitdauer bis zum Umschalten des Komparators bestimmt wird. Bei einem spezifikationsgemäßen Widerstandswert der Sicherung schaltet der Komparator seinen Zustand innerhalb der anhand des Kontrollwiderstands ermittelten Zeitdauer um. Durch Anpassung der Referenzspannung des Komparators kann die Zeitdauer, innerhalb der der Komparator für einen spezifikationsgemäßen Widerstandswert der Sicherung umschalten soll, verringert und somit die Testzeit verkürzt werden. Dieses Verfahren ist jedoch auf das Testen von nicht schaltbaren elektrischen Verbindungen und insbesondere auf die Ermittlung eines Zustands von ausreichender Leitfähigkeit (das heißt: eines ausreichend geringen Widerstandes) beschränkt. Ferner beschreibt das Dokument US 2009/079439 A1 ein Efuse-System und eine Methode zum Testen des Efuse-Systems, wobei ein Widerstand der elektronischen Sicherung erfasst wird. Dieser Widerstand hängt davon ab, ob die elektronische Sicherung durchgebrannt ist oder nicht. Es wird also lediglich eine vollständige Zerstörung der elektronischen Sicherung detektiert, und keine graduelle Veränderung der Funktionsqualität der elektronischen Sicherung.

Es besteht daher ein Bedarf an einem verbesserten Testverfahren, mit dem der Arbeitszustand einer schaltbaren Efuse erfasst werden kann, wobei insbesondere zwischen einem sicheren Arbeitszustand, in dem die elektrische Last bei Überstrom zuverlässig von der Versorgungsspannung getrennt wird, und einem unsicheren Arbeitszustand, bei dem die elektrische Last bei Überstrom nicht zuverlässig von der Versorgungsspannung getrennt wird, unterschieden werden soll. Ferner kann es auch erforderlich sein, Arbeitszustände zu erkennen, bei denen die elektrische Last im Überstromfall zwar getrennt wird, wobei jedoch gewisse Parameter (beispielsweise die Abschaltzeit oder die verbleibende Restleitfähigkeit entlang der Efuse) nicht den spezifizierten Sollwerten entsprechen.

Der Erfindung liegt in einem ersten Aspekt die Aufgabe zu Grunde, ein verbessertes Verfahren zum Testen einer schaltbaren Efuse anzugeben. Diese Aufgabe wird erfindungsgemäß durch ein Verfahren mit den Merkmalen des Anspruchs 1 gelöst.

Der Erfindung liegt ferner die Aufgabe zu Grunde, ein verbessertes Testsystem zum Testen einer schaltbaren Efuse anzugeben. Diese Aufgabe wird erfindungsgemäß durch ein Testsystem mit den Merkmalen des Anspruchs 8 gelöst.

Vorteilhafte Ausgestaltungen der Erfindung sind Gegenstand der Unteransprüche.

Der erste Aspekt der Erfindung betrifft ein Verfahren zum Testen einer schaltbaren Efuse.

Bei einer schaltbaren Efuse, die zwischen mindestens einem leitenden und einem nicht-leitenden Zustand umschaltbar ist und über die mindestens eine elektrische Last mit einer Versorgungsspannungsquelle elektrisch verbunden wird, sind mindestens ein erster, funktionsfähiger Arbeitszustand und ein zweiter, nichtfunktionsfähiger Arbeitszustand unterscheidbar.

Im ersten Arbeitszustand wird die mindestens eine elektrische Last von der Versorgungsspannungsquelle zuverlässig getrennt, wenn der über die Efuse von der elektrischen Last aufgenommene Strom für eine vorbestimmte Zeitdauer oberhalb einer vorbestimmten Nennstromstärke liegt. Im zweiten Arbeitszustand ist eine Trennung der elektrischen Last unter diesen Bedingungen nicht oder nicht zuverlässig gewährleistet.

Die mindestens eine elektrische Last ist so ausgebildet, dass sie eine Versorgungsunterbrechung (das heißt: eine Trennung von der Versorgungsspannungsquelle) für eine vorbestimmte Unterbrechungshöchstdauer toleriert.

Die Unterbrechungshöchstdauer ist die maximale Zeitspanne, während der ein Betrieb der elektrischen Last unter Berücksichtigung sämtlicher Toleranzen ohne Speisung durch die Versorgungsspannungsquelle aufrechterhalten werden kann, beispielsweise mittels interner Pufferspeicher in der elektrischen Last.

Bei einem Testverfahren zur Überprüfung des Arbeitszustands einer schaltbaren Efuse wird die schaltbare Efuse von einem leitenden Zustand für eine Testzeit in einen nicht-leitenden Zustand umgeschaltet, wobei die Testzeit höchstens gleich der kürzesten Unterbrechungshöchstdauer sämtlicher von der schaltbaren Efuse versorgten elektrischen Lasten ist.

Während der Testzeit wird der die schaltbare Efuse im nicht-leitenden Zustand durchfließende Reststrom als Ist-Restromwert erfasst und mit mindestens einem Soll-Reststromwert verglichen. Der schaltbaren Efuse wird ein erster (funktionsfähiger) Arbeitszustand zugeordnet, wenn der erfasste Ist-Reststromwert unterhalb des mindestens einen Soll-Reststromwerts liegt. Wenn mindestens ein Soll-Reststromwert kleiner als der oder gleich dem erfassten Ist-Reststromwert ist, dann wird der schaltbaren Efuse ein weiterer Arbeitszustand zugeordnet.

Mit dem Verfahren ist es möglich, eine schaltbare Efuse hinsichtlich ihrer Funktionssicherheit zu prüfen, ohne den laufenden Betrieb einer dadurch versorgten elektrischen Last zu beeinträchtigen und ohne eine redundante Struktur von schaltbaren Efuses zu verwenden. Dadurch ist eine besonders kostensparende, energiesparende und engmaschige Funktionsüberprüfung von schaltbaren Efuses möglich.

Bei einer Ausführungsform des Verfahrens wird der Ist-Reststromwert erfasst, indem ein Istwert einer Entladezeitdauer der Entladung eines parallel zur elektrischen Last von der Versorgungsspannungsquelle gespeisten Kondensators über einen Widerstand erfasst wird. Der erfasste Istwert der Entladezeitdauer wird mit mindestens einem Sollwert für die Entladezeitdauer verglichen, der für eine schaltbare Efuse in jeweils einem Arbeitszustand ermittelt wird.

Beispielsweise kann ein erster Sollwert für die Entladezeitdauer in einem vollständig funktionsfähigen Arbeitszustand einer schaltbaren Efuse und ein zweiter Sollwert für die Entladezeitdauer in einem noch funktionsfähigen, aber bereits degradierten Arbeitszustand ermittelt werden. Sodann wird der Istwert der Entladezeitdauer eines über eine zu testende schaltbare Efuse mit der Versorgungsspannungsquelle verbundenen Kondensators erfasst und mit dem ersten und zweiten Sollwert verglichen. Wenn der Istwert der erfassten Entladezeitdauer unterhalb des ersten Sollwerts liegt, wird der zu testenden schaltbare Efuse der Arbeitszustand "funktionsfähig" zugeordnet. Wenn der Istwert der erfassten Entladezeitdauer unterhalb des zweiten Sollwerts, aber nicht unterhalb des ersten Sollwerts liegt, wird der zu testenden schaltbaren Efuse der Arbeitszustand "eingeschränkt funktionsfähig" zugeordnet. Wenn der Istwert der erfassten Entladezeitdauer nicht unterhalb des zweiten Sollwerts liegt, wird der zu testenden schaltbaren Efuse der Arbeitszustand "nicht funktionsfähig" zugeordnet.

Bei einer Weiterbildung dieser Ausführungsform des Verfahrens wird eine Messspannung über dem Kondensator erfasst und, beispielsweise mittels eines Komparators, mit einer Referenzspannung verglichen. Die Referenzspannung kann beispielsweise von einer verstellbaren Referenzspannungsquelle bereitgestellt werden.

Ein Taktsignal mit vorbestimmter Taktperiode kann während einer Zeitdauer abgezählt werden, in der die Messspannung oberhalb der Referenzspannung liegt und die Efuse in den nicht-leitenden Zustand umgeschaltet wurde. Der Istwert der Entladezeitdauer kann aus dem Produkt des Zählerstandes und der Periodendauer des Taktsignals ermittelt werden. Beispielsweise kann, wenn die Referenzspannung ausreichend niedrig (nahe am Spannungswert der Messspannung für den vollständig entladenen Kondensator) gewählt ist, direkt das Produkt des Zählerstandes mit der Periodendauer gebildet werden. Zur Verkürzung der Messdauer ist es aber auch möglich, eine höhere Referenzspannung zu wählen und den daraus ermittelten (entsprechend niedrigeren) Zählerstand zu extrapolieren, der sich für eine Referenzspannung ergeben würde, die nahe bei der Messspannung über dem nahezu vollständig entladenen Kondensator liegen würde.

Der für eine Zeitmessung gemäß dieser Weiterbildung des Verfahrens erforderliche Zähler ist, ebenso wie ein präziser Taktgenerator, sehr leicht und kostengünstig umsetzbar oder bereits vorhanden. Zudem kann der Zählvorgang sehr leicht auf den Zeitbereich beschränkt werden, in dem der Kondensator über den Widerstand entladen wird. So verfügen Zählerschaltungen oder Zählerbausteine typischerweise über einen "Capture" - Eingang, welcher mit einem positiven (logisch wahren) Pegel und/oder einer steigenden (oder fallenden) Flanke belegt sein muss, damit der Zählvorgang ausgelöst bzw. der Zählerzustand erfasst wird. Beispielsweise kann dieser Pegel und/oder diese Flanke für einen solchen "Capture" - Eingang aus der Ausgangsspannung eines Komparators gewonnen werden, mit dem die Messspannung mit der Referenzspannung verglichen wird. Auch eine logische Verknüpfung (beispielsweise mit einer Signalspannung, welche das Umschalten der schaltbaren Efuse vom leitenden in den nicht-leitenden Zustand auslöst) ist sehr leicht, beispielsweise über eine Transistor-Transistor-Logik (TTL) umsetzbar.

Somit kann anhand der Entladezeitdauer auf besonders einfache Weise ermittelt werden, ob die Efuse wie vorgesehen die Verbindung zu der elektrischen Last trennt, wenn sie von dem leitenden in den nicht-leitenden Zustand umgeschaltet wird. An einem Istwert der Entladezeitdauer, der oberhalb eines vorbestimmten Korridors um einen zugeordneten Sollwert der Entladezeitdauer liegt (entsprechend einer nicht ausreichend schnellen Entladung des Kondensators), kann ein zu hoher Leckstrom der schaltbaren Efuse im nicht-leitenden Zustand oder ein Kurzschluss über der schaltbaren Efuse erkannt werden. In diesem Fall ist die Betriebssicherheit der elektrischen Last dadurch gefährdet, dass sie bei einem Fehler (Überschreiten des Nennstromes) nicht von der Versorgungsspannung getrennt wird.

Liegt der Istwert der Entladezeitdauer unterhalb dieses vorbestimmten Korridors, kann eine zu geringe Aufladung des Kondensators erkannt werden, die beispielsweise dadurch bewirkt sein kann, dass die schaltbare Efuse, wenn sie im leitenden Zustand angesteuert wird, nicht vollständig durchschaltet (dass also der Widerstand entlang der Efuse zu hoch ist).

Bei einer Weiterbildung des Verfahrens wird oder werden ein aktueller Temperaturwert und/oder ein aktueller Wert der Versorgungsspannung und/oder eine Abweichung des Kapazitätswerts des Kondensators und/oder eine Abweichung des Widerstandswerts des Widerstands vom jeweiligen Nennwert ermittelt und zur Korrektur des Istwerts der Entladezeitdauer herangezogen.

Beispielsweise kann der Ist-Kapazitätswert des Kondensators kleiner als dessen Nenn-Kapazitätswert sein und dadurch ein kürzerer Istwert der Entladezeitdauer bewirkt werden. Um zu verhindern, dass eine schaltbare Efuse falsch positiv als fehlerhaft eingeordnet wird, wird ein korrigierter (entsprechend verringerter) Sollwert der Entladezeitdauer anhand des tatsächlichen (korrigierten) Ist-Kapazitätswerts des Kondensators bestimmt. Eine solche Korrektur kann besonders einfach in ausreichender Näherung durch Skalierung des Sollwerts der Entladezeitdauer (entsprechend dem Verhältnis des Sollwerts zum Istwert des Kapazitätswerts) gewonnen werden. Selbstverständlich kann (rechnerisch gleichwertig) auch der Istwert der Entladezeitdauer entsprechend invers skaliert werden.

In gleicher Weise ist eine Korrektur des Ist-Widerstandswerts bei einer Abweichung vom Nennwert des Widerstandswerts möglich.

Auch die Einflüsse der Temperatur der schaltbaren Efuse und/oder weiterer Bauelemente sowie von Schwankungen der Versorgungsspannung können durch rechnerische Korrektur des Sollwerts der Entladezeitdauer (oder, rechnerisch gleichwertig, des Istwerts der Entladezeitdauer) berücksichtigt werden. Dabei kann es möglich sein, dass derartige Schwankungen oder Abweichungen nicht-linear in die rechnerische Korrektur eingehen. In diesem Fall wird es sich als vorteilhaft erweisen, Korrekturtabellen zu erfassen, beispielsweise eine Korrekturtabelle zur Berücksichtigung der Arbeitstemperatur der Efuse, bei der für eine Reihe von Temperaturwerten jeweils ein Korrekturterm erfasst ist, der additiv, multiplikativ oder gemäß einem anderen funktionalen Zusammenhang auf den erfassten Istwert der Entladezeitdauer anzuwenden ist, wenn die jeweilige Temperatur erfasst wurde. In analoger Weise kann eine Korrekturtabelle auch für verschiedene Werte der Versorgungsspannung angelegt werden.

Derartige Korrekturtabellen können in einem nicht-flüchtigen Speicher abgelegt und von einer Testauswerteeinheit abgerufen werden, nachdem der Istwert der Entladezeitdauer wie beschrieben erfasst wurde. In einem derartigen nicht-flüchtigen Speicher können insbesondere auch Korrekturwerte zur Berücksichtigung der Abweichungen des Istwerts des Widerstandswertes und/oder des Istwerts des Kapazitätswerts gespeichert werden, die einmalig (bezogen auf jeweils eine schaltbare Efuse) in einem Kalibrierschritt erfasst werden.

Diese Weiterbildung der Ausführungsform ermöglicht den Einsatz wenig präziser Bauelemente (Widerstände, Kondensatoren) und die Durchführung des Verfahrens auch in sehr unterschiedlichen Situationen (bei verschiedenen, stark schwankenden Versorgungsspannungen und Temperaturen). Sie verbessert somit die Robustheit des Verfahrens und ermöglicht eine einfachere und kostengünstigere Umsetzung.

Bei einer beispielhaften Ausführungsform des Verfahrens ist die Testzeit (Shutdown-Zeit), während der die schaltbare Efuse in den nicht-leitenden Zustand versetzt wird, auf 100 Mikrosekunden beschränkt. Da elektrische Lasten, insbesondere solche, die im Automobil eingesetzt werden, über Pufferspeicher (beispielsweise interne Kapazitäten) verfügen, die ausreichend groß sind, um eine derart kurze Unterbrechung ohne Einschränkung zu überbrücken, können mit dieser Ausführungsform des Verfahrens Efuses in sehr vielen Betriebssituationen (mit unterschiedlichsten elektrischen Lasten) getestet werden.

Bei einer Ausführungsform des Verfahrens werden erfasste Ist-Reststromwerte (beispielsweise aus Istwerten der Entladezeitdauer ermittelte Ist-Reststromwerte) fortlaufend gespeichert. Daraus wird fortlaufend ein dynamisch angepasster Soll-Reststromwert derart ermittelt, dass der schaltbaren Efuse ein weiterer Arbeitszustand (das heißt: ein vom Arbeitszustand "funktionsfähig" abweichender Arbeitszustand) zugeordnet wird, wenn ein aktuell erfasster Ist-Reststromwert von zurückliegend erfassten Ist-Reststromwerten statistisch auffällig abweicht. Auf diese Weise können allmähliche Vorgänge (beispielsweise alterungsbedingtes Driften), welche die Funktionsfähigkeit der schaltbaren Efuse nicht beeinträchtigen, von potenziell fehlerträchtigen plötzlichen Änderungen unterschieden werden. Dadurch ist die Erkennung fehlerhafter schaltbarer Efuses mit besonders hoher Spezifität und Sensitivität möglich.

Bei einer Ausführungsform des Verfahrens wird die schaltbare Efuse zur Versorgung einer elektrischen Last in einem Fahrzeug angeordnet. Derartige elektrische Lasten (beispielsweise Steuergeräte, Sensorik zur Erfassung einer Fahrzeugumgebung oder Komponenten eines Antriebsstrangs) sind besonders sicherheits- und zuverlässigkeitsrelevant. Ihre Abschaltung im Fehlerfall (z.B. bei Überschreiten eines Nennstromwerts) ist daher besonders wichtig.

Bei einer Ausführungsform des Verfahrens wird ein erster Arbeitszustand "funktionsfähig" der schaltbaren Efuse dann zugeordnet, wenn der Ist-Reststromwert unterhalb eines ersten Soll-Reststromwerts liegt. Ein zweiter Arbeitszustand "eingeschränkt funktionsfähig" wird dann zugeordnet, wenn der Ist-Reststromwert zwischen dem ersten und einem zweiten Soll-Reststromwert liegt, der höher als der erste Soll-Reststromwert ist. Ein dritter Arbeitszustand "nicht funktionsfähig" wird dann zugeordnet, wenn der Ist-Reststromwert über dem zweiten Soll-Reststromwert liegt.

Analog können auch, wenn der Ist-Reststromwert anhand des Istwertes der Entladezeitdauer bestimmt wird, ein erster (vergleichsweise kleinerer) Sollwert und ein zweiter (vergleichsweise größerer) Sollwert der Entladezeitdauer der Zuordnung des ersten bis dritten Arbeitszustands zugrunde gelegt werden.

Diese Ausführungsform hat den Vorteil, dass bereits degradierte, vorläufig aber noch funktionsfähige schaltbare Efuses (beispielsweise mit einem erhöhten, aber noch innerhalb des vorgesehenen Toleranzbereiches liegenden Leckstrom im gesperrten, nicht-leitenden Zustand) rechtzeitig erkannt werden, so dass sie in planmäßigen Wartungsarbeiten ausgewechselt werden können.

Nach einem weiteren Aspekt betrifft die Erfindung ein Testsystem, das zur Durchführung des vorangehend beschriebenen Verfahrens eingerichtet ist. Das Testsystem umfasst erfindungsgemäß eine Testschaltung, eine Teststeuereinheit und eine Testauswerteeinheit.

Die Testschaltung ist zur Erfassung des Ist-Reststromwerts eingerichtet, der durch die schaltbare Efuse hindurchfließt, wenn diese in den nicht-leitenden Zustand geschaltet ist.

Die Teststeuereinheit ist dafür eingerichtet, die schaltbare Efuse aus dem leitenden Zustand für eine vorbestimmte Testzeit in den nicht-leitenden Zustand umzuschalten.

Die Testauswerteeinheit ist dafür eingerichtet, den durch die Testschaltung erfassten Ist-Reststromwert mit mindestens einem Soll-Reststromwert zu vergleichen.

Die Vorteile des Testsystems entsprechen denen des damit durchführbaren Verfahrens gemäß dem ersten Aspekt der Erfindung.

Bei einer Ausführungsform umfasst die Testschaltung ein RC-Glied mit einem Widerstand und einem dazu parallel geschalteten Kondensator sowie einen Komparator und einen Zeitgeber.

Das RG-Glied ist über die schaltbare Efuse mit einer Versorgungsspannungsquelle verbindbar. Der Komparator ist dafür eingerichtet, eine Messspannung, die über dem RC-Glied anliegt, mit einer Referenzspannung zu vergleichen, die beispielsweise von einer vorzugsweise einstellbaren Referenzspannungsquelle bereitgestellt wird.

Der Zeitgeber ist mit der Teststeuereinheit und dem Komparator verbunden und dafür eingerichtet, die Zeit zu erfassen, die von dem Zeitpunkt des Umschaltens der schaltbaren Efuse von dem leitenden in den nicht-leitenden Zustand durch die Teststeuereinheit bis zu dem Zeitpunkt verstreicht, zu dem der Komparator ermittelt, dass die Messspannung über dem RC-Glied die Referenzspannung erreicht oder unterschreitet.

Mit einer derartigen Testschaltung kann ein Istwert der Entladezeitdauer des Kondensators über dem Widerstand erfasst werden, aus dem der Ist-Reststromwert durch die gesperrte (in den nicht-leitenden Zustand geschaltete) schaltbare Efuse ermittelt werden kann. Alternativ kann an Stelle eines Vergleiches des Ist-Reststromwerts mit einem Soll-Reststromwert auch der erfasste Istwert der Entladezeitdauer mit einem zum Soll-Reststromwert korrespondierenden Sollwert der Entladezeitdauer verglichen werden.

Diese Ausführungsform ermöglicht somit eine besonders einfache und genaue Prüfung des Ist-Reststromwertes und damit eine Prüfung der Funktionsfähigkeit der schaltbaren Efuse.

Bei einer Ausführungsform umfasst die Testauswerteeinheit einen Analog-Digital-Wandler (ADC), der zur Erfassung der Versorgungsspannung eingerichtet ist und/oder der, im Zusammenwirken mit einem Temperatursensor, zu Erfassung der Temperatur der schaltbaren Efuse eingerichtet ist. Alternativ oder zusätzlich umfasst die Testauswerteeinheit gemäß dieser Ausführungsform einen nicht-flüchtigen Speicher zur Ablage mindestens eines Kalibrationswertes und/oder mindestens eines zurückliegend erfassten Ist-Reststromwertes.

Diese Ausführungsform weist den Vorteil auf, dass Schwankungen der Arbeitstemperatur der Efuse oder der Versorgungsspannung sowie Fertigungstoleranzen der elektronischen Bauelemente, beispielsweise des Widerstands und des Kondensators in dem RC-Glied, bei der Testung der Efuse berücksichtigt werden können. Dadurch ist ein besonders spezifischer und sensitiver Test der Efuse bei zugleich besonders einfachem und kostengünstigem Aufbau des Testsystems möglich. Weitere Vorteile entsprechen denen der korrespondierenden Ausführungsform des oben beschriebenen Verfahrens gemäß dem ersten Aspekt der Erfindung.

Ausführungsbeispiele der Erfindung werden im Folgenden anhand von Zeichnungen näher erläutert.

Dabei zeigen:

Fig. 1    schematisch ein Testsystem für eine schaltbare Efuse,

Fig. 2    schematisch den Zeitverlauf einer Testspannung während einer Testphase und

Fig. 3    schematisch einen Ablaufplan für die Testauswertung einer Messung an einer schaltbaren Efuse.

Einander entsprechende Teile sind in allen Figuren mit den gleichen Bezugszeichen versehen.

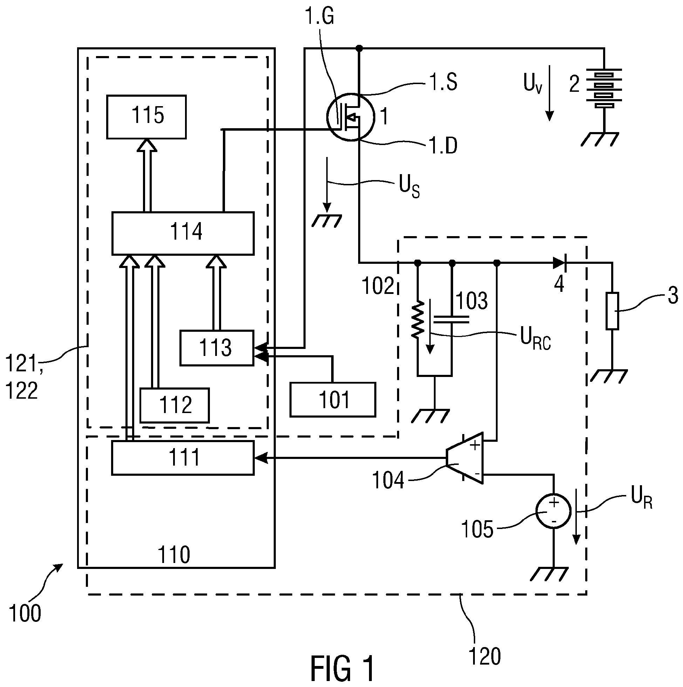

Figur 1 zeigt rein beispielhaft und schematisch ein Testsystem 100 zur Überprüfung des Arbeitszustands einer schaltbaren Efuse 1, die zwischen einer Versorgungsspannungsquelle 2 und einer elektrischen Last 3 angeordnet ist.

Im vorliegenden Ausführungsbeispiel ist die schaltbare Efuse 1 als n-Kanal-Metall-Oxid-Halbleiter-Feldeffekttransistor (NMOS FET) ausgebildet, es sind jedoch in gleicher Weise auch andere Ausprägungsformen eines Halbleiterschaltelements möglich. Vorliegend ist die Source-Elektrode 1.S des NMOS FET mit der Versorgungsspannungsquelle 2 verbunden. Die Drain-Elektrode 1.D ist über eine Diode 4 mit der elektrischen Last 3 verbunden. Die Flussrichtung der Diode 4 weist von der schaltbaren Efuse 1 zur elektrischen Last 3.

Die Versorgungsspannungsquelle 2 kann beispielsweise als Fahrzeugbatterie eines nicht näher dargestellten Fahrzeugs ausgebildet sein, die eine Versorgungsspannung $U_V$ von typischerweise zwischen 8 Volt bis 17 Volt abgibt. Alternativ oder zusätzlich kann die Versorgungsspannungsquelle 2 Teil eines elektrischen Bordnetzes des Fahrzeuges sein. Die elektrische Last 3 kann beispielsweise als Steuergerät, aktiver Sensor, Aktor oder als sonstiges, elektrisch betriebenes Teilsystem des Fahrzeugs ausgebildet sein.

Die elektrische Last 3 muss fortwährend mit der Versorgungsspannung $U_V$ versorgt werden, kann jedoch (beispielsweise mittels interner Kapazitäten oder sonstiger Pufferspeicher) Unterbrechungen der Versorgungsspannung $U_V$ für eine gewisse Zeitdauer überbrücken. Typischerweise können dabei Versorgungsunterbrechungen bis zu einer Unterbrechungshöchstdauer von etwa 100 Mikrosekunden überbrückt werden.

Das Testsystem 100 umfasst einen Mikrocontroller 110 mit externer Beschaltung, die (typischerweise zusammen mit der schaltbaren Efuse 1) auf einer nicht näher dargestellten Leiterplatte angeordnet ist. Auf dem Mikrocontroller 110 sind ein Zeitgeber 111, ein nicht-flüchtiger Speicher 112 und ein mehrkanaliger Analog-Digital-Wandler (ADC) 113 angeordnet.

Ferner weist der Mikrocontroller 110 eine Ausführungseinheit zur Ausführung von Programmanweisungen auf, die in Figur 1 nicht näher dargestellt ist. Von dieser Ausführungseinheit ausführbarer Programmcode umfasst eine Efuse-Testsoftware 114 und eine Anwendungssoftware 115, die in einem gemeinsamen oder in getrennten Programmspeichern des Mikrocontrollers 110 abgelegt sein können. Der/die Programmspeicher des Mikrocontrollers 110 ist/sind in Figur 1 nicht näher dargestellt. Beispielsweise kann ein nicht-flüchtiger Speicher 112 als Flash-Speicher ausgebildet und zur Ablage sowohl von Programmanweisungen als auch zur nichtflüchtigen Speicherung von Daten eingerichtet sein.

Der mehrkanalige ADC 113 tastet auf einem ersten Kanal den Wert der Versorgungsspannung $U_V$ und auf einem zweiten Kanal den Wert eines peripheren Temperatursensors 101 ab. Der Temperatursensor 101 erfasst die Temperatur der Leiterplatte, auf der die Efuse 1 und die externe Beschaltung des Mikrocontrollers 110 angeordnet sind.

Der Zeitgeber 111 kann beispielsweise als rücksetzbarer Zähler ausgebildet sein, der auf einen Zählerstart hin einen internen Takt des Mikrocontrollers 110 zählt.

Ferner stellt der Mikrocontroller 110, gesteuert von den Programmanweisungen der Efuse-Testsoftware 114, eine Signalspannung $U_S$ bereit, die an die Gate-Elektrode 1.G der schaltbaren Efuse 1 geführt ist. Mit der Signalspannung $U_S$ kann die schaltbare Efuse 1 zwischen einem leitenden Zustand (beispielsweise bei $U_S \approx 5$ Volt) und einem nicht-leitenden Zustand (beispielsweise bei $U_S \approx 0$ Volt) umgeschaltet werden.

Zwischen der Drain-Elektrode 1.D der schaltbaren Efuse 1 und der Masse ist ein RC-Glied 102, 103 angeordnet, das von einem Widerstand 102 und einem dazu parallel geschalteten Kondensator 103 gebildet wird und das eine Zeitkonstante $\tau$ aufweist, die sich aus dem Produkt des Widerstandswerts R und der Kapazität des Kondensators C ergibt ($\tau = R \cdot C$).

Die Messspannung $U_{RC}$ über dem RC-Glied 102, 103 wird von einem Komparator 104 erfasst und mit einer Referenzspannung $U_R$ verglichen, die von einer Referenzspannungsquelle 105 bereitgestellt wird. Die Komparator-Ausgangsspannung $U_K$ am Ausgang des Komparators 104 nimmt einen hohen Pegel (der einem positiven Wert, beispielsweise $U_K \approx 3$ Volt entspricht) an, wenn die Messspannung $U_{RC}$ größer oder gleich der

Referenspannung $U_R$ ist. Die Komparator-Ausgangsspannung $U_K$ am Ausgang des Komparators 104 nimmt einen niedrigen Pegel an (der einem vergleichsweise kleineren Wert, beispielsweise $U_K \approx 0$ Volt entspricht), wenn die Messspannung $U_{RC}$ kleiner als die Referenzspannung $U_R$ ist.

In dem Ausführungsbeispiel gemäß Figur 1 umfasst das Testsystem 100 eine Testschaltung 120, eine Teststeuereinheit 121 und eine Testauswerteeinheit 122.

Die Testschaltung 120 wird vorliegend von dem Zeitgeber 111, dem RC-Glied 102, 103 mit dem Widerstand 102 und dem Kondensator 103, dem Komparator 104 und der Referenzspannungsquelle 105 gebildet.

Die Teststeuereinheit 121 wird vorliegend von dem Mikrocontroller 110 mit der Efuse-Testsoftware 114 gebildet. Die Testauswerteeinheit 122 wird vorliegend von dem Mikrocontroller 110 mit dem ADC 113 und dem nicht-flüchtigen Speicher 112 sowie dem Temperatursensor 101 gebildet. Es ist aber auch möglich, dass die Teststeuereinheit 121 und die die Testauswerteeinheit 122 voneinander unabhängig realisiert sind.

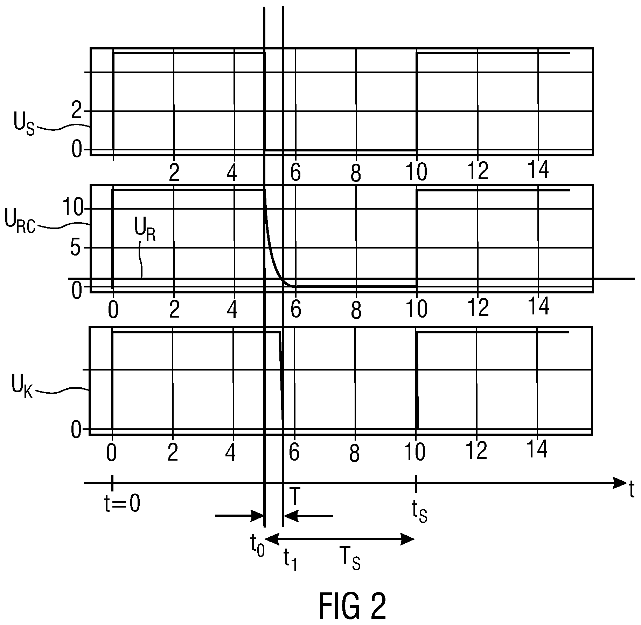

Die Funktionsweise des Testsystems 100 wird nachfolgend anhand von Figur 2 näher erläutert, in der schematisch der Verlauf der Signalspannung $U_S$, der Messspannung $U_{RC}$ sowie der Komparator-Ausgangsspannung $U_K$ dargestellt sind.

Zu einem ersten Zeitpunkt $t_0$ senkt die Efuse-Testsoftware 114 die Signalspannung $U_S$ derart ab (beispielsweise von $U_S \approx 5$ Volt auf $U_S \approx 0$ Volt), dass die schaltbare Efuse 1 von dem leitenden in den nicht-leitenden Zustand umgeschaltet wird, indem der NMOS-FET sperrt. Durch die Diode 4 wird verhindert, dass interne Kapazitäten oder Pufferspeicher der elektrischen Last 3 den Kondensator 103 des RC-Glieds 102, 103 weiter speisen.

Synchron zum Absenken der Signalspannung $U_S$ startet die Efuse-Testsoftware 114 den Zeitgeber 111.

Daraufhin entlädt sich der Kondensator 103 über den Widerstand 102, so dass die Messspannung $U_{RC}$ vom Wert der Versorgungsspannung $U_V$ ausgehend in der Art einer abklingenden Exponentialfunktion abfällt

$$U_{RC}(t) = U_V \cdot e^{\frac{t_0-t}{R \cdot C}}, t \geq t_0$$

**bis sie zu** einem zweiten Zeitpunkt $t_1$ den Wert der Referenzspannung $U_R$ unterschreitet.

Mit dem Unterschreiten der Referenzspannung $U_R$ wechselt die Komparator-Ausgangsspannung $U_K$ von dem hohen Pegel (der dem logischen Wert Eins oder "wahr" entspricht) in den niedrigen Pegel (der dem logischen Wert Null oder "falsch" entspricht). Dadurch wird zum zweiten Zeitpunkt $t_1$ der Zeitgeber 111 gestoppt (beispielsweise, indem die Komparator-Ausgangsspannung $U_K$ auf einen Capture - Eingang eines Zählers des Zeitgebers 111 gelegt wird).

Der Wert des Zeitgebers 111 (Zählerstand zum

zweiten Zeitpunkt $t_1$) repräsentiert somit die Entladezeitdauer T, während welcher der Kondensator 103 über den Widerstand 102 auf den Wert der Referenzspannung $U_R$ entladen wurde.

Zu einem dritten Zeitpunkt $t_S$ hebt die Efuse-Testsoftware 114 die Signalspannung $U_S$ wieder derart an (beispielsweise von $U_S \approx 0$ Volt auf $U_S \approx 5$ Volt), dass die Efuse 1 von dem nicht-leitenden in den leitenden Zustand umgeschaltet wird, indem der NMOS-FET auf Durchlass geschaltet wird. Somit wird ab dem dritten Zeitpunkt $t_S$ die elektrische Last 3 wieder von der Versorgungsspannungsquelle 2 versorgt.

Der Abstand zwischen dem ersten Zeitpunkt $t_0$ und dem dritten Zeitpunkt $t_S$ ist so gewählt, dass die Shutdown-Zeitdauer $T_S$, während der die elektrische Last 3 nicht versorgt wird, zwar ausreichend groß für eine Entladung des Kondensators 103 auf die Referenzspannung $U_R$ des Komparators 104, aber erheblich kürzer als die Unterbrechungshöchstdauer ist, während der die elektrische Last 3 unversorgt bleiben kann, ohne nicht mehr ordnungsgemäß zu funktionieren. Dadurch wird eine Beeinträchtigung des Betriebs der elektrischen Last 3 verhindert.

Synchron zum Anheben der Signalspannung $U_S$ im dritten Zeitpunkt $t_S$ setzt die Efuse-Testsoftware 114 den Zeitgeber 111 wieder auf Null zurück.

Nachfolgend auf den zweiten Zeitpunkt $t_1$ wertet die Efuse-Testsoftware 114 den von dem Zeitgeber 111 gelieferten Wert der Entladezeitdauer T aus. Beispielsweise kann der derart gemessene Wert der Entladezeitdauer $T$ mit einem Sollwert $T_{soll}$ verglichen werden, der sich aus dem oben bereits genannten Zusammenhang für den Entladevorgang ergibt:

$$U_{RC}(T_{soll}) = U_R = U_V \cdot e^{-\frac{T_{Soll}}{R \cdot C}}$$

In verschiedenen Betriebsumgebungen, insbesondere in einem Fahrzeug, kann die Versorgungsspannung $U_V$ erheblich variieren. Zudem können, aufgrund von Fertigungstoleranzen oder Alterungsvorgängen, der Widerstandswert R und/oder der Kapazitätswert C von einem jeweiligen Nennwert abweichen. Ferner kann das Schaltverhalten einer schaltbaren Efuse 1 und/oder das Entladeverhalten eines RC-Gliedes 102, 103 auch von der Temperatur abhängen.

Es kann sich daher als vorteilhaft erweisen, bei einer Bewertung der schaltbaren Efuse 1 nicht nur die gemessene Entladezeitdauer T, sondern darüber hinaus mindestens auch Korrekturwerte zur genauen Bestimmung des Widerstandswerts R und/oder des Kapazitätswerts C sowie insbesondere den aktuellen (zum ersten Zeitpunkt $t_0$ erfassten) Wert der Versorgungsspannung $U_V$ zu berücksichtigen.

Dabei kann aus dem oben bereits genannten Zusammenhang zu veränderten Werten $U_V'$, $R'$, $C'$ der Versorgungsspannung $U_V$, des Widerstands 102 und/oder der Kapazität des Kondensators 103 ein korrigierter Sollwert *T'* für den Vergleich mit der Entladezeitdauer *T* bestimmt werden:

$$U_{RC}(T'_{soll}) = U_R = U'_V \cdot e^{\frac{T'_{soll}}{R' \cdot C'}}$$

In analoger Weise können auch temperaturbedingte Variationen berücksichtigt werden, beispielsweise durch Erfassung von Kennlinien für das Schaltverhalten der schaltbaren Efuse 1.

Korrekturwerte, beispielsweise ein Korrekturwert $\Delta R = R' - R$ für den Widerstand 102 und/oder ein Korrekturwert $\Delta C = C - C'$ für die Kapazität des Kondensators 103 können vorteilhaft in einem Kalibrierungsschritt erfasst und auf dem nicht-flüchtigen Speicher 112 abgelegt werden.

Bei einer Ausführungsform können auch fortlaufend, in gewissen Zeitabständen oder für eine gewisse, zurückliegende Periode die jeweils erfassten Werte der Entladezeitdauer T auf dem nicht-flüchtigen Speicher 112 abgelegt werden. Durch Vergleich eines aktuell erfassten Wertes mit zurückliegenden Werten kann mittels der Efuse-Testsoftware 114 eine allmähliche Degradation der schaltbaren Efuse 1 besonders frühzeitig festgestellt werden, insbesondere bereits dann, wenn die Funktionsfähigkeit vorläufig noch gewährleistet ist.

Beispielsweise kann ein Arbeitszustand der schaltbaren Efuse 1 als ein Wert der Liste {"funktionsfähig", "funktionsfähig, aber degradiert", "nicht funktionsfähig"} ermittelt und von der Efuse-Testsoftware 114 an die Anwendungssoftware 115 übergeben werden.

Die Anwendungssoftware 115 kann basierend auf diesem Wert eine Fehlerreaktion auslösen, beispielsweise gewisse, von der betroffenen elektrischen Last 3 gesteuerte Funktionen eines Fahrzeugs deaktivieren oder eine Warnmeldung ausgeben.

Anhand der in Figur 2 dargestellten schematischen Spannungs-Zeitverläufe wird die Funktionsweise der in Figur 1 dargestellten schematischen Schaltung genauer erläutert. Im oberen Teil zeigt Figur 2 den Zeitverlauf der Signalspannung $U_S$, im mittleren Teil den Zeitverlauf der Messspannung $U_{RC}$ sowie im unteren Teil den Zeitverlauf der Komparator-Ausgangsspannung $U_K$ entlang der Zeitachse *t*.

Zum Zeitpunkt *t* = 0 (in dem die Versorgungsspannung $U_V$ eingeschaltet oder angelegt ist) wird die Signalspannung $U_S$ auf einen hohen Wert (typischerweise von zwischen 10 Volt und 15 Volt) geschaltet, der ausreicht, um die als NMOS FET ausgebildete schaltbare Efuse 1 durchzusteuern. Entsprechend wird die über dem RC-Glied 102, 103 anliegende Messspannung $U_{RC}$ näherungsweise den Wert der Versorgungsspannung $U_V$ annehmen (vermindert lediglich über den im Vergleich dazu geringfügigen Spannungsabfall entlang der Source-Drain-Strecke, der typischerweise 100 Millivolt bis 1 Volt beträgt).

Der Komparator 104 vergleicht die Messspannung $U_{RC}$ mit der Referenzspannung $U_R$. Die Referenzspannung $U_R$ ist auf einen Wert geringfügig oberhalb von Null gesetzt. Die Referenzspannung $U_R$ kann beispielsweise so bestimmt werden, dass für einen Leckstrom, welcher bei einer gesperrten schaltbaren Efuse 1 gerade noch als zulässig angesehen wird, der daraus resultierende Spannungsabfall über dem RC-Glied 102, 103 berechnet wird. Wird dieser Spannungsabfall nicht überschritten, so kann die schaltbare Efuse 1 als funktionsfähig angesehen werden. Typischerweise wird dazu die Referenzspannung $U_R$ etwa 10 bis 20 Prozent des Wertes der Versorgungsspannung $U_V$ betragen.

Bei funktionsfähig durchgeschalteter (im leitenden Zustand befindlicher) schaltbarer Efuse 1 ist somit die Messspannung $U_{RC}$ erheblich größer als die Referenzspannung $U_R$. Am Ausgang des Komparators 104 liegt somit ein hoher positiver Spannungswert der Komparator-Ausgangsspannung $U_K$ (abhängig von der Schaltungstechnologie und der Versorgung des Komparators 104 typischerweise 2 Volt bis 5 Volt) an.

Zu einem ersten Zeitpunkt $t_0$ löst die Efuse-Testsoftware 114, die auf dem Mikrocontroller 110 abläuft, eine kurzzeitige Sperrung der schaltbaren Efuse 1 aus, um deren Funktionsfähigkeit zu testen. Hierzu wird bis zu einem dritten Zeitpunkt $t_S$ (also für eine Shutdown-Zeitdauer $T_S = t_S - t_0$) die Signalspannung $U_S$ auf einen niedrigen Pegel gelegt, der einem Wert von 0 Volt oder nahe 0 Volt entspricht.

Bei funktionsfähiger schaltbarer Efuse 1 wird dadurch der Source-Drain-Strom vollständig oder nahezu vollständig unterbrochen. Der Kondensator 103 entlädt sich daraufhin über den Widerstand 102, wobei die Spannung über dem Kondensator 103 (welche gleich der Messspannung $U_{RC}$ ist) gemäß der eingangs schon beschriebenen abklingenden Exponentialfunktion durch die Zeitkonstante $\tau = R \cdot C$ des RC-Glieds 102, 103 bestimmt abfällt. Dabei wird nach einer als Entladezeitdauer T bezeichneten Zeitspanne zu einem zweiten Zeitpunkt $t_1 = t_0 + T$ der Wert der Referenzspannung $U_R$ unterschritten. Synchron oder mit vernachlässigbarer Verzögerung schaltet der Ausgang des Komparators 104 von dem hohen in den niedrigen Pegel der Komparator-Ausgangsspannung $U_K$ um.

Die Shutdown-Zeitdauer $T_S$ ist ausreichend groß bemessen, um (bei funktionsfähiger schaltbarer Efuse 1) das Abklingen der Messspannung $U_{RC}$ sicher beobachten zu können. Es wird sich dabei als vorteilhaft erweisen, als Shutdown-Zeitdauer $T_S$ ein Mehrfaches der Entladezeit T vorzusehen, innerhalb der bei funktionsfähiger (insbesondere. ausreichend gut sperrender) schaltbarer Efuse 1 die Messspannung $U_{RC}$ von der Versorgungsspannung $U_V$ auf die Referenzspannung $U_R$ abfällt.

Zugleich ist die Shutdown-Zeitdauer $T_S$ so klein bemessen, dass die elektrische Last 3 einen Ausfall der Versorgungsspannung $U_V$ während dieser Zeitspanne ohne Beeinträchtigung toleriert. Eine solche Zeitspanne, während der die elektrische Last 3 ohne Beeinträchtigung sicher (das heißt: unter Berücksichtigung möglicher Toleranzen sowohl der elektrischen Last 3 als auch der Versorgungsspannung $U_V$ sowie weiterer Toleranzen) auch bei Fortfall der Versorgungsspannung $U_V$ betrieben werden kann, wird hier und im Folgenden als Unterbrechungshöchstdauer bezeichnet.

Beispielsweise kann, ausgehend von einer bekannten Unterbrechungshöchstdauer, die Shutdown-Zeitdauer $T_S$ als ein Bruchteil (beispielsweise die Hälfte oder ein Drittel) der Unterbrechungshöchstdauer gewählt werden. Sodann werden das RC-Glied 102, 103 und die Referenzspannung $U_R$ derart dimensioniert, dass bei einem maximal zulässigen Leckstrom durch eine gesperrte schaltbare Efuse 1 und bei maximal zulässiger Versorgungsspannung $U_V$ der Kondensator 103 über den Widerstand 102 während einer Entladezeitdauer T auf den Wert der Referenzspannung $U_R$ entladen wird, die einen Bruchteil (beispielsweise ein Fünftel oder ein Zehntel) der Shutdown-Zeitdauer $T_S$ beträgt.

Zur Bestimmung der Entladezeitdauer T kann, beispielsweise mittels eines weiteren, in Figur 1 nicht näher dargestellten Komparators oder durch Umsetzung auf eine Transistor-Transistor-Logik (TTL) ein Capture-Signal generiert werden, das einen hohen Pegel und/oder eine ansteigende Flanke dann annimmt, wenn die Signalspannung $U_S$ einen niedrigen Pegel annimmt und zugleich die Komparator-Ausgangsspannung $U_K$ noch bei einem hohen Pegel verharrt, und das ansonsten einen niedrigen Pegel und/oder eine fallende Flanke annimmt. Mittels eines solchen Capture-Signals kann ein Zählvorgang eines bekannten Taktsignals an dem Zeitgeber 111 ausgelöst werden, nämlich bei einem hohen Pegel und/oder einer steigenden Flanke, bzw. gestoppt werden, nämlich bei einem niedrigen Pegel und/oder einer fallenden Flanke. In diesem Fall entspricht der Zählerstand des Zeitgebers 111, multipliziert mit der Periodendauer des bekannten Taktsignals, genau der Entladezeitdauer T. Selbstverständlich kann der Zählvorgang auch dann gestoppt werden, wenn der Zählerstand des Zeitgebers 111 einen maximalen Zählerstand überschreitet. Zudem kann die Anwendungssoftware 115 ein Start- und/oder Stop-Signal an den Zeitgeber 111 senden, um den Zählvorgang auszulösen und/oder zu beenden.

Alternativ kann die Komparator-Ausgangsspannung $U_K$ auch direkt auf einen negierten Capture-Eingang des Zeitgebers 111 derart geführt werden, dass der Zeitgeber 111 ein Taktsignal während der Zeitspanne zwischen dem zweiten Zeitpunkt $t_1$ und dem dritten Zeitpunkt $t_S$ zählt, während der die Komparator-Ausgangsspannung $U_K$ auf dem niedrigen Pegel liegt. Bei dieser Ausführungsform ergibt sich die Entladezeitdauer T aus der Differenz zwischen der genau bekannten (von der Efuse-Testsoftware 114 ausgelösten) Shutdown-Zeitdauer $T_S$ und der gemessenen Zeitspanne

$$T = T_S - (t_S - t_1).$$

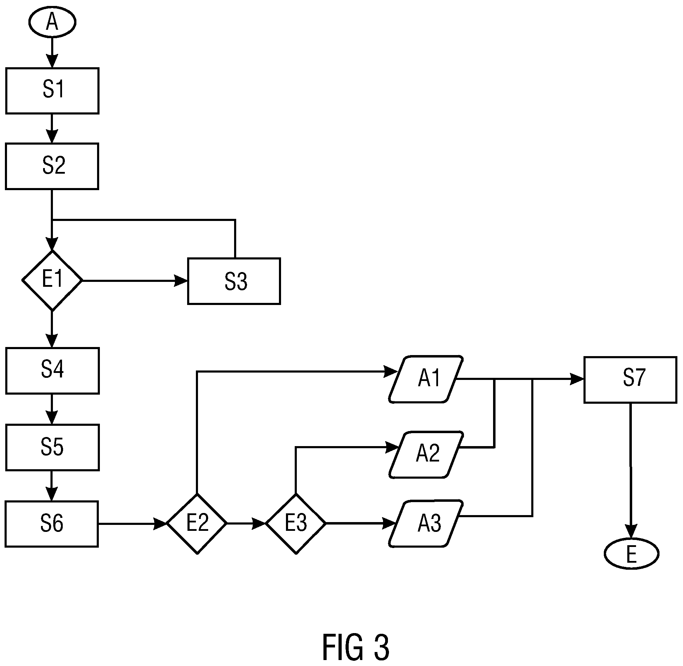

Figur 3 zeigt schematisch und rein beispielhaft einen Ablaufplan zur Erläuterung der von der Efuse-Testsoftware 114 vorgenommenen Auswertung. Der Ablauf startet bei einem Startpunkt A und endet bei einem Endpunkt E.

Ausgehend vom Startpunkt A werden in einem ersten Schritt S1 der aktuelle Wert der Versorgungsspannung $U_V$ sowie der aktuelle Temperaturwert eingelesen, der von dem (typischerweise nahe der schaltbaren Efuse 1 angeordneten) Temperatursensor 101 erfasst wird. Beide Werte werden mittels des ADC 113 abgetastet und diskretisiert.

In einem zweiten Schritt S2 wird zum zweiten Zeitpunkt $t_1$ die Signalspannung $U_S$ auf den niedrigen Pegel abgesenkt und dadurch die schaltbare Efuse 1 gesperrt (in den nicht-leitenden Zustand versetzt). Zugleich wird im zweiten Schritt S2 der Zeitgeber 111 gestartet.

In einem nachfolgenden ersten Entscheidungsschritt E1 wird geprüft, ob die mit dem Zeitgeber 111 erfasste Zeitdauer, während der die schaltbare Efuse 1 gesperrt ist, die vorbestimmte Shutdown-Zeitdauer $T_S$ bereits erreicht oder überschritten hat. Mit anderen Worten:' es wird geprüft, ob der aktuelle Zeitpunkt $t$ vor dem dritten Zeitpunkt $t_S$ liegt $t < t_0 + T_S = t_S$.

Wenn die Shutdown-Zeitdauer $T_S$ noch nicht erreicht ist, wird in dem nachfolgenden dritten Schritt S3 das Verfahren über eine vorbestimmte Wartezeitdauer hinweg pausiert und dann erneut der erste Entscheidungsschritt E1 ausgeführt. Die vorbestimmte Wartezeitdauer ist so ausreichend klein bemessen, dass das Erreichen der vorbestimmten Shutdown-Zeitdauer $T_S$ mit hoher Genauigkeit erfassbar ist. Bevorzugt ist die vorbestimmte Wartezeitdauer eine Taktperiode eines dem Zeitgeber 111 zugeführten, von diesem abgezählten Taktsignals.

Wenn im ersten Entscheidungsschritt E1 festgestellt wird, dass die vorbestimmte Shutdown-Zeitdauer $T_S$ erreicht wurde, wird in einem nachfolgenden vierten Schritt S4 die schaltbare Efuse 1 wieder auf Durchgang (in einen leitenden Zustand) geschaltet.

Nachfolgend wird in einem fünften Schritt S5 die Entladezeitdauer T ausgelesen, beispielsweise als mit der Taktperiode multiplizierter Zählerstand eines Zählers, der in dem Zeitraum zwischen dem ersten Zeitpunkt $t_0$ und dem zweiten Zeitpunkt $t_1$, in welchem die Komparator-Ausgangsspannung $U_K$ auf einem hohen Pegel, die Signalspannung $U_S$ aber auf einem niedrigen Pegel liegt, das Taktsignal abzählt.

In einem darauffolgenden sechsten Schritt S6 wird die ausgelesene Entladezeitdauer T angepasst, indem Kalibrationsdaten bezüglich des Widerstandswertes R und des Kapazitätswertes C des RC-Glieds 102, 103 und/oder der aktuelle (das heißt: im ersten Schritt S1 erfasste) Wert der Versorgungsspannung $U_V$ und/oder die vom dem Temperatursensor 101 erfasste Temperatur berücksichtigt werden.

Beispielsweise können die Abweichung ΔR von einem Nenn-Widerstandswert R und die Abweichung $\Delta C$ von einem Nenn-Kapazitätswert C während eines (in Figur 3 nicht näher dargestellten) Kalibrationsschrittes erfasst und im nicht-flüchtigen Speicher 112 abgelegt werden. Zusätzlich können beispielsweise Kennlinien, die das Zeit-Schaltverhalten des NMOS FET, der die Efuse 1 bildet und/oder Kennlinien, die den Source-Drain-Leckstrom der schaltbaren Efuse 1 jeweils in Abhängigkeit von der Temperatur abbilden, in dem nicht-flüchtigen Speicher 112 abgelegt sein. Diese Daten werden im sechsten Schritt S6 ausgelesen und zur Anpassung der ausgelesenen Entladezeitdauer $T$ derart verwendet, das ein korrigierter Wert der Entladezeitdauer $T$ ermittelt wird, der das Verhalten der schaltbaren Efuse 1 unabhängig von Fertigungstoleranzen, temperaturunabhängig und unabhängig von der Versorgungsspannung $U_V$ beschreibt.

In einem nachfolgenden zweiten Entscheidungsschritt E2 wird die derart korrigierte Entladezeitdauer $T$ mit einem ersten Schwellwert verglichen. Liegt die Entladezeitdauer $T$ unterhalb dieses ersten Schwellwertes, so wird die schaltbare Efuse 1 als ohne Einschränkungen funktionsfähig angesehen. Es wird dann in einem ersten Ausgabeschritt A1 ein erster Ausgabecode "funktionsfähig" ausgegeben (der selbstverständlich auch als Bitmuster oder Literal kodiert sein kann).

Liegt die Entladezeitdauer $T$ nicht unterhalb des ersten Schwellwertes, so wird nachfolgend auf den zweiten Entscheidungsschritt E2 in einem dritten Entscheidungsschritt E3 geprüft, ob die Entladezeitdauer $T$ unterhalb eines zweiten Schwellwertes liegt, der größer als der erste Schwellwert gewählt ist.

Liegt die Entladezeitdauer $T$ unterhalb dieses zweiten Schwellwertes, so wird die schaltbare Efuse 1 als eingeschränkt funktionsfähig angesehen. Dies kann beispielsweise bedeuten, dass die schaltbare Efuse 1 mit gewisser Wahrscheinlichkeit nur noch für eine bestimmte Restlebensdauer als funktionsfähig anzusehen ist und vor Ablauf dieser Restlebensdauer ausgewechselt werden sollte. Es wird dann in einem zweiten Ausgabeschritt A2 ein vom ersten Ausgabecode verschiedener zweiter Ausgabecode "eingeschränkt funktionsfähig" ausgegeben (der selbstverständlich auch als Bitmuster oder Literal kodiert sein kann).

Liegt die Entladezeitdauer $T$ nicht unterhalb des ersten Schwellwertes, so wird nachfolgend auf den zweiten Entscheidungsschritt E2 in einem dritten Entscheidungsschritt E3 geprüft, ob die Entladezeitdauer $T$ unterhalb eines zweiten Schwellwertes liegt, der größer als der erste Schwellwert gewählt ist.

Liegt die Entladezeitdauer $T$ nicht unterhalb dieses zweiten Schwellwertes, so wird die schaltbare Efuse 1 als nicht funktionsfähig angesehen. Es wird dann in einem dritten Ausgabeschritt A3 ein vom ersten und vom zweiten Ausgabecode jeweils verschiedener dritter Ausgabecode "nicht funktionsfähig" ausgegeben (der selbstverständlich auch als Bitmuster oder Literal kodiert sein kann).

Die im zweiten und dritten Entscheidungsschritt E2, E3 herangezogenen Schwellwerte können insbesondere durch statistische Untersuchungen bestimmt werden. Beispielsweise können fortlaufend Werte für die Entladezeitdauer $T$ über eine ausreichend große Stichprobe von schaltbaren Efuses 1 erfasst werden. Zu einer Teilmenge von ausgefallenen schaltbaren Efuses 1 aus dieser Stichprobe kann dann retrospektiv ein Schwellwert bezüglich der Entladezeitdauer $T$ bestimmt werden, mit dem ein ausreichend großer Anteil dieser Ausfälle rechtzeitig erkannt worden wäre, ohne eine unakzeptabel hohe Anzahl von falsch positiven Detektionen (das heißt: anhand dieses Schwellwertes als demnächst ausfallend markierten, tatsächlich aber weiterhin funktionsfähigen schaltbaren Efuses 1) zu provozieren.

Unter "Ausgabe eines Ausgabecodes" ist insbesondere die Übertragung eines solchen Ausgabecodes an die Anwendungssoftware 115 zu verstehen. Beispielsweise kann die Anwendungssoftware 115 für den Fall, dass die Efuse-Testsoftware 114 den Ausgabecode "eingeschränkt funktionsfähig" ermittelt hat, eine Warnung und/oder einen Hinweis, bis wann die schaltbare Efuse 1 möglichst ausgetauscht werden soll, ausgeben. Für den Fall, dass die Efuse-Testsoftware 114 den Ausgabecode "nicht funktionsfähig" ermittelt hat, kann die Anwendungssoftware 115 ein sicherheitskritisches Teilsystem, das über die schaltbare Efuse 1 versorgt wird, abschalten.

Nachfolgend auf den ersten, zweiten beziehungsweise dritten Ausgabeschritt A1, A2, A3 wird in einem siebten Schritt S7 der Wert der Entladezeitdauer $T$ im nicht-flüchtigen Speicher 112 abgelegt. Anschließend wird der Endpunkt E des Verfahrens erreicht.

Zur Vereinfachung der Darstellung wurde im Vorangehenden angenommen, dass die Schritte S5, S6, und S7, die Entscheidungsschritte E2 und E3, sowie die Ausgabeschritte A1, A2, und A3 zeitlich nach dem vierten Schritt S4 durchgeführt werden, in dem die schaltbare Efuse 1 wieder auf Durchgang (in einen leitenden Zustand) geschaltet wird. Im Prinzip ist es auch denkbar, dass die vorgenannten Schritte bereits ab dem frühesten Zeitpunkt der Verfügbarkeit der Entladezeitdauer $T$, nämlich ab dem zweiten Zeitpunkt $t_1$, durchgeführt werden. Dies hätte den technischen Vorteil, dass das Wiedereinschalten der Efuse vom Ergebnis der Auswertung der Entladezeitdauer $T$ abhängig gemacht werden könnte. Z.B. könnten für als nicht funktionsfähig angesehene Efuses gar nicht mehr aktiviert werden.

**Patentansprüche**

1. Testverfahren zur Überprüfung des Arbeitszustands einer zwischen mindestens einem leitenden und einem nicht-leitenden Zustand umschaltbaren Efuse (1), über welche eine elektrische Last (3) mit einer Versorgungsspannungsquelle (2) elektrisch verbunden wird, wobei die elektrische Last (3) eine Versorgungsunterbrechung für eine vorbestimmte Unterbrechungshöchstdauer toleriert,
**dadurch gekennzeichnet, dass**

- die schaltbare Efuse (1) für eine Testzeit, $T_S$, die höchstens gleich der Unterbrechungshöchstdauer der elektrischen Last (3) ist, von dem leitenden in den nicht-leitenden Zustand umgeschaltet wird,
- der die schaltbare Efuse (1) während der Testzeit, $T_S$, durchfließende Reststrom mittels einer Testschaltung (120) als Ist-Reststromwert erfasst und
- mit mindestens einem Soll-Reststromwert verglichen wird,

wobei ein erster Arbeitszustand zugeordnet wird, wenn der Ist-Reststromwert unterhalb des mindestens einen Soll-Reststromwert liegt und andernfalls ein weiterer Arbeitszustand zugeordnet wird.

2. Testverfahren nach Anspruch 1,
**dadurch gekennzeichnet, dass**
der Ist-Restromwert durch einen Istwert einer Entladezeitdauer, $T$, der Entladung eines von der schaltbaren Efuse (1) parallel zur elektrischen Last (3) versorgten Kondensators (103) über einen Widerstand (102) erfasst wird und mit mindestens einem für die schaltbare Efuse (1) für jeweils einen Arbeitszustand ermittelten, einem Soll-Reststromwert zugeordneten Sollwert der Entladezeitdauer, $T$, verglichen wird.

3. Testverfahren nach Anspruch 2,
**dadurch gekennzeichnet, dass**
eine Messspannung, $U_{RC}$, über dem Kondensator (103) erfasst und mit einer Referenzspannung, $U_R$, verglichen wird und ein Taktsignal während einer Zeitdauer abgezählt wird, während der die Messspannung, $U_{RC}$, oberhalb der Referenzspannung, $U_R$, liegt, wobei der Istwert der Entladezeitdauer, $T$, aus dem Produkt eines Zählerstandes und einer Periodendauer des Taktsignales ermittelt wird.

4. Testverfahren nach einem der Ansprüche 2 bis 3,
**dadurch gekennzeichnet, dass**
ein aktueller Temperaturwert und/oder ein aktueller Wert einer Versorgungsspannung, $U_V$, und/oder eine Abweichung des Kapazitätswertes des Kondensators (103) und/oder des Widerstandswertes des Widerstands (102) von jeweils einem Nennwert ermittelt wird/werden und zur Korrektur des Istwerts der Entladezeitdauer, $T$, herangezogen wird/werden.

5. Testverfahren nach einem der vorhergehenden Ansprüche,
**dadurch gekennzeichnet, dass**

der Soll-Reststromwert abhängig von zurückliegend erfassten Ist-Reststromwerten derart angepasst wird, dass der schaltbaren Efuse (1) ein weiterer Arbeitszustand zugeordnet wird, wenn ein aktuell erfasster Ist-Reststromwert von zurückliegend erfassten Ist-Reststromwerten statistisch auffällig abweicht.

6. Testverfahren nach einem der vorhergehenden Ansprüche,
**dadurch gekennzeichnet, dass**
die schaltbare Efuse (1) zur Versorgung der elektrischen Last (3) in einem Fahrzeug angeordnet wird.

7. Testverfahren nach einem der vorhergehenden Ansprüche,
**dadurch gekennzeichnet, dass**
ein erster Arbeitszustand "funktionsfähig" zugeordnet wird, wenn der Ist-Reststromwert unterhalb eines ersten Soll-Reststromwerts liegt, ein zweiter Arbeitszustand "eingeschränkt funktionsfähig" zugeordnet wird, wenn der Ist-Reststromwert zwischen dem ersten und einem höheren zweiten Soll-Reststromwert liegt, und ein dritter Arbeitszustand "nicht funktionsfähig" zugeordnet wird, wenn der Ist-Reststromwert über dem zweiten Soll-Reststromwert liegt.

8. Testsystem (100) zur Durchführung eines Verfahrens nach einem der vorhergehenden Ansprüche umfassend eine Testschaltung (120), eine Teststeuereinheit (121) und eine Testauswerteeinheit (122),
**dadurch gekennzeichnet, dass**

- die Testschaltung (120) zur Erfassung des Ist-Reststromwerts eingerichtet ist, der die schaltbare Efuse (1) in dem nicht-leitenden Zustand durchfließt,
- die Teststeuereinheit (121) zur Umschaltung der schaltbaren Efuse (1) zwischen dem leitenden und dem nicht-leitenden Zustand für die vorbestimmte Testzeit, $T_S$, eingerichtet ist und
- die Testauswerteeinheit (122) zum Vergleich des von der Testschaltung (120) erfassten Ist-Reststromwerts mit mindestens einem Soll-Reststromwert eingerichtet ist.

9. Testsystem (100) nach Anspruch 8,
**dadurch gekennzeichnet, dass**
die Testschaltung (120) ein RC-Glied (102, 103) umfassend einen Widerstand (102) und einen parallel dazu geschalteten Kondensator (103), einen Komparator (104) und einen Zeitgeber (111) umfasst,

- wobei das RC-Glied (102, 103) über die schaltbare Efuse (1) mit einer Versorgungsspannungsquelle (2) verbindbar ist,
- wobei der Komparator (104) zum Vergleichen der über dem RC-Glied (102, 103) anliegenden Messspannung, $U_{RC}$, mit einer Referenzspannung, $U_R$, eingerichtet ist und
- wobei der Zeitgeber (111) von der Teststeuereinheit (121) mit dem Umschalten der schaltbaren Efuse (1) aus dem leitenden in den nichtleitenden Zustand gestartet und von dem Komparator (104) gestoppt wird, wenn die Messspannung, $U_{RC}$, die Referenzspannung, $U_R$, erreicht oder unterschreitet.

10. Testsystem (100) nach Anspruch 7 oder 8,
**dadurch gekennzeichnet, dass**
die Testauswerteeinheit (122)

    - einen Analog-Digital-Wandler (113),

        o der zur Erfassung eines Istwertes der Versorgungsspannung, $U_V$, und/oder
        o der, mittels eines Temperatursensors (101), zur Erfassung der Temperatur der schaltbaren Efuse (1) eingerichtet ist,

    - und/oder einen nicht-flüchtigen Speicher (112) zur Ablage mindestens eines Kalibrationswertes und/oder mindestens eines Ist-Reststromwertes umfasst.

## Claims

1. Test method for verifying the operating state of an efuse (1) which can be switched between at least one conductive and one non-conductive state and via which an electrical load (3) is electrically connected to a supply voltage source (2), the electrical load (3) tolerating a supply interruption for a predetermined maximum interruption duration,
**characterized in that**

    - the switchable efuse (1) is switched from the conductive to the non-conductive state for a test time, $T_S$, which is at most equal to the maximum interruption duration of the electrical load (3),
    - the residual current which flows through the switchable efuse (1) during the test time, $T_S$, is recorded as the actual residual current value by means of a test circuit (120) and
    - is compared with at least one target residual current value,

a first operating state being assigned if the actual residual current value is below the at least one target residual current value, and otherwise a further operating state being assigned.

2. Test method according to claim 1,
**characterized in that**
the actual residual current value is recorded across a resistor (102) by way of an actual value of a discharge time period, $T$, of the discharge of a capacitor (103) supplied by the switchable efuse (1) in parallel with the electrical load (3) and is compared with at least one target value of the discharge time period, $T$, assigned to a target residual current value determined for the switchable efuse (1) for one operating state in each case.

3. Test method according to claim 2,
**characterized in that**
a measuring voltage, $U_{RC}$, is recorded across the capacitor (103) and compared with a reference voltage, $U_R$, and a clock signal is counted down during a time period during which the measuring voltage, $U_{RC}$, lies above the reference voltage, $U_R$, the actual value of the discharge time period, $T$, being determined from the product of a counter reading and of a period duration of the clock signal.

4. Test method according to either of claims 2 or 3,
**characterized in that**
a current temperature value and/or a current value of a supply voltage, $U_V$, and/or a deviation of the capacitance value of the capacitor (103) and/or of the resistance value of the resistor (102) is/are each determined from a nominal value and is/are used to correct the actual value of the discharge time period, $T$.

5. Test method according to any of the preceding claims,
**characterized in that**
the target residual current value is adjusted on the basis of previously recorded actual residual current values in such a way that the switchable efuse (1) is assigned a further operating state if a currently recorded actual residual current value deviates statistically significantly from previously recorded actual residual current values.

6. Test method according to any of the preceding claims,
**characterized in that**
the switchable efuse (1) is arranged to supply the electrical load (3) in a vehicle.

7. Test method according to any of the preceding claims,
**characterized in that**
a first operating state is assigned as "functional" if the actual residual current value is below a first target residual current value, a second operating state is assigned as "limited functionality" if the actual residual current value is between the first and a higher second target residual current value, and a third operating state is assigned as "non-functional" if the actual residual current value is above the second target residual current value.

8. Test system (100) for carrying out a method according to any of the preceding claims, comprising a test circuit (120), a test control unit (121) and a test evaluation unit (122),
**characterized in that**

- the test circuit (120) is configured to record the actual residual current value which flows through the switchable efuse (1) in the non-conductive state,
- the test control unit (121) is configured to switch the switchable efuse (1) between the conductive and the non-conductive state for the predetermined test time, $T_S$, and
- the test evaluation unit (122) is configured to compare the actual residual current value recorded by the test circuit (120) with at least one target residual current value.

9. Test system (100) according to claim 8,
**characterized in that**
the test circuit (120) comprises an RC member (102, 103) comprising a resistor (102) and a capacitor (103) connected in parallel therewith, a comparator (104) and a timer (111),

- it being possible for the RC member (102, 103) to be connected to a supply voltage source (2) via the switchable efuse (1),
- the comparator (104) being configured to compare the measuring voltage, $U_{RC}$, applied above the RC member (102, 103) with a reference voltage, $U_R$, and
- the timer (111) being started by the test control unit (121) with the switching of the switchable efuse (1) from the conductive into the non-conductive state and being stopped by the comparator (104) if the measuring voltage, $U_{RC}$, reaches or falls below the reference voltage, $U_R$.

10. Test system (100) according to claim 7 or claim 8,
**characterized in that**
the test evaluation unit (122) comprises

- an analog-to-digital converter (113),

  o which is configured to record an actual value of the supply voltage, $U_V$, and/or
  o which is configured to record the temperature of the switchable efuse (1) by means of a temperature sensor (101),

- and/or a non-volatile memory (112) for storing at least one calibration value and/or at least one actual residual current value.

## Revendications

1. Procédé de test permettant de vérifier l'état de fonctionnement d'un fusible électronique « efuse » (1) pouvant être commuté entre au moins un état conducteur et un état non conducteur, par l'intermédiaire duquel une charge électrique (3) est connectée électriquement à une source de tension d'alimentation (2), dans lequel la charge électrique (3) tolère une interruption d'alimentation pendant une durée maximale d'interruption prédéterminée,
**caractérisé en ce que**

- l'efuse (1) commutable est commuté de l'état conducteur à l'état non conducteur pendant un temps de test, $T_S$, qui est au plus égal à la durée maximale d'interruption de la charge électrique (3),
- le courant résiduel traversant l'efuse (1) commutable pendant le temps de test, $T_S$, est détecté par le biais d'un circuit de test (120) comme valeur de courant résiduel réelle et
- est comparé à au moins une valeur de courant résiduel de consigne,

dans lequel un premier état de fonctionnement est attribué si la valeur de courant résiduel réelle est inférieure à l'au moins une valeur de courant résiduel de consigne et, dans le cas contraire, un autre état de fonctionnement est attribué.

2. Procédé de test selon la revendication 1,
**caractérisé en ce que**
la valeur de courant résiduel réelle est détectée par une valeur réelle d'une durée de décharge, $T$, de la décharge d'un condensateur (103) alimenté par l'efuse (1) commutable en parallèle avec la charge électrique (3) par l'intermédiaire d'une résistance (102) et est comparée à au moins une valeur de consigne de la durée de décharge, $T$, établie pour l'efuse (1) commutable pour respectivement un état de fonctionnement et associée à une valeur de courant résiduel de consigne.

3. Procédé de test selon la revendication 2,
**caractérisé en ce que**
une tension de mesure, $U_{RC}$, est détectée par l'intermédiaire du condensateur (103) et comparée à une tension de référence, $U_R$, et un signal d'horloge est compté pendant une durée pendant laquelle la tension de mesure, $U_{RC}$, est supérieure à la tension de référence, $U_R$, dans lequel la valeur réelle de la durée de décharge, T, est établie à partir du produit d'un état de comptage et d'une durée de période du

**4.** Procédé de test selon l'une des revendications 2 à 3, **caractérisé en ce que** une valeur de température actuelle et/ou une valeur actuelle d'une tension d'alimentation, $U_V$, et/ou un écart de la valeur de capacité du condensateur (103) et/ou de la valeur de la résistance (102) par rapport à une valeur nominale respective est/sont établi(s) et est/sont utilisé(s) pour corriger la valeur réelle de la durée de décharge, $T$.

**5.** Procédé de test selon l'une des revendications précédentes, **caractérisé en ce que** la valeur de courant résiduel de consigne est adaptée en fonction de valeurs de courant résiduel réelles détectées antérieurement de telle sorte qu'un autre état de fonctionnement est attribué à l'efuse (1) commutable lorsqu'une valeur de courant résiduel réelle actuellement détectée s'écarte de manière statistiquement frappante de valeurs de courant résiduel réelles détectées antérieurement.

**6.** Procédé de test selon l'une des revendications précédentes, **caractérisé en ce que** l'efuse (1) commutable est agencé dans un véhicule pour alimenter la charge électrique (3).

**7.** Procédé de test selon l'une des revendications précédentes, **caractérisé en ce que** un premier état de fonctionnement « opérationnel » est attribué lorsque la valeur de courant résiduel réelle est inférieure à une première valeur de courant résiduel de consigne, un deuxième état de fonctionnement « opérationnel limité » est attribué lorsque la valeur de courant résiduel réelle est comprise entre la première et une seconde valeur de courant résiduel de consigne plus élevée, et un troisième état de fonctionnement « non opérationnel » est attribué lorsque la valeur de courant résiduel réelle est supérieure à la seconde valeur de courant résiduel de consigne.

**8.** Système de test (100) pour la mise en œuvre d'un procédé selon l'une des revendications précédentes, comprenant un circuit de test (120), une unité de commande de test (121) et une unité d'évaluation de test (122), **caractérisé en ce que**

- le circuit de test (120) est conçu pour détecter la valeur de courant résiduel réelle qui traverse l'efuse (1) commutable dans l'état non conducteur,
- l'unité de commande de test (121) est conçue pour commuter l'efuse (1) commutable entre l'état conducteur et l'état non conducteur pendant la durée de test, $T_S$, prédéterminée et
- l'unité d'évaluation de test (122) est conçue pour comparer la valeur de courant résiduel réelle détectée par le circuit de test (120) avec au moins une valeur de courant résiduel de consigne.

**9.** Système de test (100) selon la revendication 8, **caractérisé en ce que** le circuit de test (120) comprend un élément RC (102, 103) comprenant une résistance (102) et un condensateur (103) connecté en parallèle à celle-ci, un comparateur (104) et un temporisateur (111),

- dans lequel l'élément RC (102, 103) peut être connecté à une source de tension d'alimentation (2) par l'intermédiaire de l'efuse (1) commutable,
- dans lequel le comparateur (104) est conçu pour comparer la tension de mesure, $U_{RC}$, appliquée aux bornes de l'élément RC (102, 103) à une tension de référence, $U_R$, et
- dans lequel le temporisateur (111) est démarré par l'unité de commande de test (121) avec la commutation de l'efuse (1) commutable de l'état conducteur à l'état non conducteur et est arrêté par le comparateur (104) lorsque la tension de mesure, $U_{RC}$, atteint ou passe en dessous de la tension de référence, $U_R$.

**10.** Système de test (100) selon la revendication 7 ou 8, **caractérisé en ce que** l'unité d'évaluation de test (122) comprend

- un convertisseur analogique-numérique (113),

○ qui est conçu pour détecter une valeur réelle de la tension d'alimentation, $U_V$, et/ou
○ qui, au moyen d'un capteur de température (101), est conçu pour détecter la température de l'efuse (1) commutable,

- et/ou une mémoire non volatile (112) pour stocker au moins une valeur d'étalonnage et/ou au moins une valeur de courant résiduel réelle.

FIG 1

FIG 2

FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20010034070 A1
- US 2009079439 A1